# EUROPEAN PATENT SPECIFICATION

(11) **EP 2 724 841 B1**
(45) Date of publication and mention of the grant of the patent: **01.11.2017**
(21) Application number: 12803320.6
(22) Date of filing: 11.06.2012
(51) Int. Cl.: B29C 65/18, B29C 65/00, B29C 63/16, B29C 35/02, B32B 37/10, H01L 31/048, H01L 31/18

(54) **DIAPHRAGM FOR PRODUCING SOLAR CELL MODULE AND METHOD FOR PRODUCING SOLAR CELL MODULE**
MEMBRAN ZUR HERSTELLUNG EINES SOLARZELLENMODULS UND VERFAHREN ZUR HERSTELLUNG EINES SOLARZELLENMODULS
DIAPHRAGME POUR LA PRODUCTION D'UN MODULE PHOTOVOLTAÏQUE ET PROCÉDÉ POUR LA PRODUCTION D'UN MODULE PHOTOVOLTAÏQUE

(30) Priority: 22.06.2011 JP 2011138763; 03.02.2012 JP 2012021823
(43) Date of publication of application: 30.04.2014
(73) Proprietor: Kureha Elastomer Co., Ltd., Osaka 541-0056 (JP)
(72) Inventor: MOURI, Nobuyuki, Mie 519-1113 (JP); TAKAJYOU, Tomohiko, Mie 514-0062 (JP); KITAMURA, Mitsuru, Mie 514-0062 (JP); DOI, Toshiaki, Mie 514-0062 (JP); UCHIYAMA, Ryuji, Mie 514-0062 (JP)
(74) Representative: White, Duncan Rohan
(86) International application number: PCT/JP2012/064896
(87) International publication number: WO 2012/176642

(56) References cited:
- EP-A1- 2 541 621
- WO-A1-2004/030900
- WO-A1-2010/131716
- WO-A1-2011/105623
- WO-A2-2011/017391
- CN-A- 101 847 667
- DE-A1- 10 316 774
- JP-A- 9 051 114
- JP-A- H0 951 114
- JP-A- 2004 281 834
- JP-A- 2004 281 834

## Description

### TECHNICAL FIELD

The present invention relates to a diaphragm for a vacuum press device that is used in producing a photovoltaic module, and to a method for producing a photovoltaic module.

### BACKGROUND ART

Known examples of diaphragms for producing a photovoltaic module include one using halogenated butyl rubber (patent document 1) and one using silicone rubber into which reinforcing fibers have been embedded (patent document 2).

Photovoltaic modules are produced by packaging photovoltaic cells using laminate materials such as heat-resistant glass plates; adhesive resin sheets of ethylene vinyl acetate resin (hereinbelow "EVA"), polyvinyl butyral (PVB), or the like; or moisture-proof sheets such as aluminum foil. One example of a method of production involves stacking an EVA sheet, a photovoltaic cell, an EVA sheet, and a moisture-proof sheet in the stated order onto a heat-resistant glass plate, and cross-linking the EVA sheets while also heating under a vacuum to adhesively bond same together. One method for carrying out the bonding would be a vacuum press format, which is a method of laminating by clamping bonding members between a lower heater panel and an upper diaphragm.

In the step for bonding a photovoltaic cell panel using EVA sheets described above, a laminate body comprising the EVA sheets and the photovoltaic cell is first placed on the heater panel, which has been set to a temperature at which the EVA sheets are cross-linked, and then pressure is applied with the diaphragm from above to press-bond the laminate body together. At this time, the temperature and time range at which the EVA sheets are cross-linked must be maintained. One example of such cross-linking conditions has conventionally been to perform a primary cross-linking at 135-155°C for about 5 minutes and then perform a secondary cross-linking at 150-160°C for about 15 to 20 minutes. The primary cross-linking is carried out by hot pressing, and the conditions for this primary cross-linking are greatly affected by the durability of the rubber sheet of the diaphragm included as part of the pressing machine. The two-stage cross-linking has the purpose of completely cross-linking the EVA sheets and in many instances is carried out using an oven.

However, recent years have come to see the adoption of a method of production in which the total cross-linking time is reduced by omitting the secondary cross-linking and cross-linking the EVA sheets with only the primary cross-linking, at temperatures exceeding 145°C.

A conventional diaphragm used in the bonding step is made of silicone rubber and withstands 5,000 or more cycles of pressing, where the primary cross-linking step represents one cycle of pressing. A millable silicone rubber has been used as the silicone rubber used in these diaphragms made of silicone rubber.

When a conventional diaphragm made of silicone rubber is used in the method of production for reducing the total cross-linking time as described above, however, the diaphragm made of silicone rubber breaks at about 1,000 cycles of pressing.

When a butyl rubber is used as the diaphragm, the butyl rubber softens and ends up sticking to the laminated body comprising the EVA sheets and photovoltaic cell.

### PRIOR ART DOCUMENT

### PATENT DOCUMENT

Patent Document 1: Japanese Patent No. 4308769
Patent Document 2: Japanese Laid-Open Patent Publication No. 2004-281834
WO 2011/017391 A2 discloses edge reinforced elastomeric membranes.
DE 103 16 774 A1 discloses a membrane useful as a laminator for producing photovoltaic cells.
EP 2 541 621 A1 (Art. 54(3)-EPC-document) discloses a diaphragm sheet.

### SUMMARY OF THE INVENTION

### PROBLEMS TO BE SOLVED BY THE INVENTION

The present invention has been contrived in order to address the problems of such description, it being an object thereof to provide a rubber diaphragm of excellent durability that does not readily break in a production method for reducing the total cross-linking time by cross-linking EVA sheets with one cycle of hot pressing at higher temperature and in less time, as well as a method for producing a photovoltaic module in which the diaphragm is used.

### MEANS FOR SOLVING THE PROBLEMS

Aspects of the present invention are provided in the independent claims.

Also, disclosed herein is a diaphragm for producing a photovoltaic module. The diaphragm is a rubber diaphragm for a vacuum press device that is used in producing a photovoltaic module, wherein:
the rubber diaphragm is a sheet of a cross-linked rubber composition that is used in order to laminate photovoltaic cells with resin sheets by hot pressing using the vacuum press device;
the cross-linked rubber composition is a cross-linked rubber composition of an EPDM; and
the cross-linked rubber composition is cross-linked a rubber composition comprising the EPDM, a cross-linking agent, and at least one selected from vulcanization accelerators and vulcanization accelerator auxiliaries.

A rubber diaphragm is also disclosed wherein a surface that comes into contact with at least the resin sheets when the hot pressing is carried out comprises a bumpy surface.

A diaphragm for producing a photovoltaic module is disclosed wherein in particular the resin sheets are EVA sheets and the cross-linked rubber composition is a cross-linked rubber composition that can be used in hot pressing conditions for cross-linking the EVA sheets. In particular, a diaphragm is disclosed wherein the hot pressing conditions are conditions under which the EVA sheets are cross-linked by two-stage cross-linking. Here, "one-stage cross-linking" refers to cross-linking the EVA sheets under one set of cross-linking conditions (cross-linking temperature and cross-linking time). The rubber diaphragm according to claim 1 is characterized in that the EPDM is an EPDM that has been polymerized using a single-site catalyst such as a metallocene catalyst and in that the ratio of the EPDM in relation to the total amount of rubber is 10 mass% or more.

Also, a diaphragm is disclosed wherein a butyl rubber is blended into the EPDM, less than 75 parts by mass being blended in relation to the total amount of the EPDM and butyl rubber together.

Here, "hot pressing" refers to pressure bonding with the diaphragm from above and heating from a lower-surface heating plate in a diaphragm-type vacuum press device.

Also disclosed herein is a method for producing a photovoltaic module comprising laminating a photovoltaic cell using EVA sheets, the method comprises:
a step in which the photovoltaic cell is laminated by the EVA sheets being cross-linked by hot pressing using a vacuum press device in which the diaphragm made of a cross-linked rubber composition of the present invention is used. In particular, the method comprises the step for laminating by cross-linking by the hot pressing which is a step for cross-linking the EVA sheets by one-stage cross-linking.

### EFFECT OF THE INVENTION

The use of the diaphragm made of a cross-linked rubber composition in the present invention improves the productivity of making photovoltaic modules, because the cross-linking of the EVA sheets is only the one-stage cross-linking by hot pressing.

### BRIEF DESCRIPTION OF THE DRAWINGS

FIG. 1 is a drawing illustrating a state of usage of a diaphragm made of a cross-linked rubber composition;
FIG. 2 is a plan view of a diaphragm that has become unusable;
FIG. 3 is a drawing illustrating a cross-sectional structure of a photovoltaic module; and
FIG. 4 is a drawing illustrating the relationship between the rubber hardness and the number of cycles of treatment.

### MODE FOR CARRYING OUT THE INVENTION

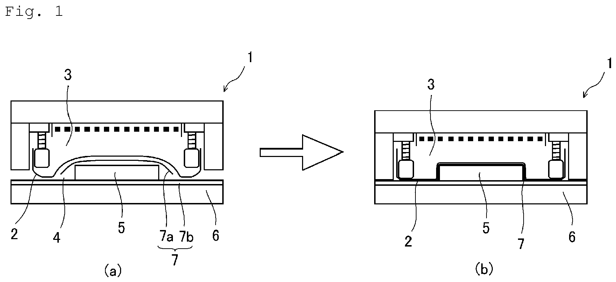

The diaphragm made of a cross-linked rubber composition of the present invention shall be described below with reference to the accompanying drawings. FIG. 1 illustrates a cross-sectional view of a vacuum press device that is used in producing photovoltaic modules and the like. FIG. 1(a) is a drawing illustrating the state before the start of vacuum pressing and FIG. 1(b) is a drawing illustrating the state during vacuum pressing.

A vacuum press device 1 is a device of a double vacuum format in which a first chamber 3 and a second chamber 4 are separated from one another by a diaphragm 2.

A photovoltaic cell 5 placed atop one side of an overall structural support 6, with an EVA sheet 7b interposed therebetween, and the surface thereof is covered with an EVA sheet 7a, and same are arranged inside the vacuum press device 1 (FIG. 1(a)).

As a pressing step, for example, each of the first chamber 3 and the second chamber 4 is evacuated to about 0.002 Pa, and the photovoltaic cell 5 surrounded by the EVA sheets 7 is heated. Once the heating reaches a predetermined temperature, the first chamber 3 is returned to atmospheric pressure (FIG. 1(b)). Returning the first chamber 3 to atmospheric pressure causes the EVA sheets 7 to be vacuum press-bonded to the photovoltaic cell 5 along with the diaphragm 2.

Maintaining this state for a predetermined length of time causes a cross-linking reaction in the EVA sheets 7 to proceed and causes the photovoltaic cell 5 to be sealed by the EVA sheets 7.

The vacuum press device 1 is cooled and thereafter the second chamber 4 is returned back to atmospheric pressure, thereby concluding the pressing step. In the pressing step, the diaphragm 2 is used while mechanical and thermal stress are applied by the vacuum press-bonding and the heating, and is replaced after a regular interval of a plurality of cycles of the pressing step. For this reason, the durability of the diaphragm 2 has a direct impact on the productivity for making photovoltaic modules and the like.

Generally, the temperature at which EVA melts is about 85°C, and the temperature at which a cross-linking reaction starts is said to be about 130°C. For this reason, there have conventionally been adopted two stages of cross-linking conditions, with which the one-stage cross-linking is carried out using hot pressing at 135-155°C for about 5 minutes and thereafter carrying out the two-stage cross-linking using an oven or the like at 150-160°C for about 15 to 20 minutes. The reason for having the one-stage cross-linking be about 5 minutes is to minimize foaming and yellowing of the EVA sheets, and the reason for having the two-stage cross-linking be at 150-160° for 15 to 20 minutes is to fully run the cross-linking reaction in the EVA sheets so as to prevent the EVA sheets from experiencing softening or the like in relation to the temperature changes in the outdoors.

To improve the productivity of making photovoltaic modules and the like, meanwhile, the present invention adopts a method of production for cross-linking the EVA sheets with solely a hot pressing in which the vacuum press device 1 is used as the conditions for cross-linking the EVA sheets. That is to say, the EVA sheets are cross-linked with only the conventional one-stage cross-linking. That is to say, one cycle of cross-linking is carried out under conditions of one cross-linking temperature and cross-linking time. For this reason, a pressing temperature of 135-180°C and a pressing time of 10 to 20 minutes are adopted as conditions for hot pressing. A conventional diaphragm 2 made of silicone rubber becomes unusable in very little time when the pressing temperature exceeds 155°C. More specifically, the number of cycles at which the conventional diaphragm 2 can be used without replacement is reduced to about one-fifth.

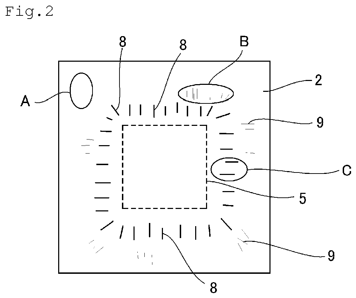

FIG. 2 is a plan view of the diaphragm 2 made of silicone rubber, which has become unusable at about 1,000 cycles of pressing under conditions of a pressing temperature of 135-180°C and pressing time of 10 to 20 minutes. As illustrated in FIG. 2, in a step for bonding the photovoltaic cell 5, the diaphragm 2 has been demonstrated to readily fracture, readily suffering cracking 8, fine crazing 9 not quite amounting to cracking, and the like at places where the mechanical stress thereof is repeatedly applied, in the direction in which the stress is applied; i.e., a direction in which expansion and contraction occur.

A portion that had not suffered degradation (the "A" portion in the drawing, an undegraded portion in which no cracking whatsoever is observed), a portion of little degradation, suffering slight degradation such as fine crazing 9 not quite amounting to cracking (the "B" portion in the drawing), and a portion of significant degradation, suffering significant cracking (the "C" portion in the drawing) in a conventional diaphragm made of silicone rubber that had suffered fracturing were examined by comparison to an unused conventional diaphragm made of silicone rubber. The results are shown in Table 1. The categories were density (g/cm³), rubber hardness (IRHD), amount of acetone extracted (mass%), IR spectroscopic analysis, and Raman spectroscopy.

The rubber hardness represents the International Rubber Hardness Degree (IRHD), a hardness scale where "0" is the hardness of a material for which the Young's modulus is zero and "100" is the hardness of a material for which the Young's modulus is infinite, and is a value denoted by the indentation depth of when a rubber sample surface that has suffered degradation is vertically indented at a constant force with a spherical surface. In table 1, the parentheses in the values of rubber hardness enclose the ratio with the unused product.

The results of the examination showed that no absorption other than the silicone component was observed in IR spectroscopic analysis and Raman spectroscopic analysis. Other examination results are shown in table 1.

**[Table 1]**

| | Properties | | |
|---|---|---|---|
| | Density (g/cm³) | Rubber hardness (IRHD) | Amount of acetone extracted (%) |
| Unused product | 1.178 | 47 (1.00) | 2.1 |
| Used product | | | |
| Undegraded portion (A) | 1.184 | 55 (1.17) | - |
| Slightly degraded portion (B) | 1.186 | 60 (1.28) | - |
| Slightly degraded portion (C) | 1.197 | 75 (1.60) | 1.2 |

As illustrated in table 1, the density increased slightly as degradation progressed, and the amount of acetone extracted showed a tendency where portions of significant degradation were reduced.

Where a prominent change was exhibited is the hardness of the rubber, which increased as degradation progressed; at the portion where degradation had progressed the most (the "C" portion in FIG. 2), the rubber hardness had increased to 1.60 times that of the unused product. Even the portion where degradation had progressed only slightly (the "B" portion in FIG. 2) exhibited a rubber hardness of a value 1.28 times that of the unused product.

The rubber hardness at the portion where no degradation of the diaphragm was observed even after usage (the "A" portion in FIG. 2) was 1.17 times that of the unused product. This shows that when a diaphragm made of silicone rubber still has a rubber hardness not greater than about 1.2 times that of an unused diaphragm, there would be obtained a rubber diaphragm that has excellent durability even under conditions where the conditions for cross-linking the EVA sheets are only a one-stage cross-linking of a press temperature of 135-180°C and pressing time of 10 to 20 minutes.

The change in rubber hardness has also been shown to be a measure of durability for diaphragms for photovoltaic modules.

A diaphragm made of silicone rubber experiences changes in rubber hardness and a decrease in durability of the diaphragm because of the peroxides included in the EVA sheets. For this reason, a rubber composition having little change in rubber hardness, other than a silicone rubber, becomes important for the diaphragm.

A rubber composition which can be used in the present invention is a cross-linked ethylene propylene diene monomer (EPDM) composition. This cross-linked EPDM composition has been found to be a rubber composition of excellent durability and little change in rubber hardness when used for a diaphragm.

Diaphragms were fabricated using the cross-linked EPDM composition illustrated in example 17 (described below), and subjected to physical testing under a pressing temperature of 160° and pressing time of 18 minutes. The results showed that cracking did not occur even at 5,000 or more cycles of pressing. When, after 5,000 cycles, the physical testing was further continued to measure the rubber hardness of portions that did experience cracking, the rubber hardness was 80. The scaling factor of hardness was 1.38, because the rubber hardness of the diaphragm at the start of testing was 58. The diaphragm made using the cross-linked EPDM composition was thus found to have excellent durability.

The EPDM is a rubber obtained by introducing a small amount of a third component to an ethylene-propylene rubber, which is a copolymer of ethylene and propylene, to endow the main chain with double bonds. Examples of the third component include ethylidene norbornene, 1,4-hexadiene, dicyclopentadiene, 5-methylene-2-norbornene, dicyclooctadiene, 5-ethylidene-2-norbornene, and other dienes.

An EPDM in which the ethylene content is 50 to 75 mass%, the diene serving as the third component is 4.5 to 8.5 mass%, and the remainder is propylene is preferable as an EPDM that can be preferably used in the present invention.

Commercially available EPDMs include the Mitsui EPT™ series from Mitsui Chemical, the Esprene™ series from Sumitomo Chemical Industries, the JSREP™ series from JSR, the Keltan™ series from DSM, the Nordel™ series from DuPont, the Epsyn™ series from Copolymer Rubber & Chemical Corp., and the Polysar™ series from Polysar Rubber Corp. Nordel™ from DuPont and Dow Elastomers is an EPDM that has been polymerized using a single-site catalyst.

An EPDM that is used in the present invention is an EPDM that has been polymerized using a single-site catalyst such as a metallocene catalyst. Such an EPDM has a narrow overall distribution of molecular weight overall, and the ethylene distribution has no distribution of molecular weight, for which reason there is relatively little crystallinity. As a result, the EPDM has excellent low-temperature properties, a low brittle temperature, and mild stress relaxation, and is therefore suitable for the present invention.

Single-site catalysts include a metallocene catalyst; such a metallocene catalyst is obtained by combining zirconocene dichloride and methylaluminoxane, and features high polymerization activity against ethylene as well as uniform active sites. Other catalysts having uniform active sites include catalysts for olefin polymerization positioned in post-metallocene catalysts, e.g., phenoxyimine catalysts (FI catalysts), pyrrole imine catalysts (PI catalysts), and the like. In contrast to these single-site catalysts, conventional catalysts such as Ziegler-Natta catalysts are called multi-site catalysts, comprising many active site structures in the catalyst. A feature of single-site catalysts is that an EPDM of a narrower molecular weight distribution, with comonomers contained in each molecule being substantially equal, is obtained.

EPDMs polymerized using a single-site catalyst include Mitsui 4045M™ and Mitsui 2060M™ from Mitsui Chemical, and Nordel IP5565™, Nordel IP4725P™, and Nordel IP4640™ from DuPont and Dow Elastomer.

In the present invention, the EPDMs described above can be used independently as a rubber component. It would also be possible to blend as appropriate two or more types of EPDM, with the aim of adjusting the Mooney viscosity, the propylene content, the vulcanization rate, the amount of oil, or the like.

As the EPDM component, there is preferably 10 mass% or more of EPDM that has been polymerized using a single-site catalyst in relation to the total amount of EPDM. Also, as the EPDM component, there is preferably not more than 75 mass% of EPDM that has been polymerized using a single-site catalyst in relation to the total amount of EPDM. More preferable is 10 to 75 mass%; particularly preferable is 25 to 75 mass%; and even more preferable is 30 to 50 mass%. When the ratio of EPDM that has been polymerized using a single-site catalyst is less than 10 mass%, the composition tends to harden more readily than when the ratio of EPDM that has been polymerized using a single-site catalyst is 50 mass%.

Other types of rubber apart from EPDM could also be blended into the EPDM rubber component.

A butyl rubber is preferable as a rubber that can be blended into the EPDM. Blending in a butyl rubber has been found to minimize any increase in the rubber hardness of the EPDM. In particular, any increase in the rubber hardness can be minimized when the butyl rubber is less than 75 parts by mass, preferably not more than 50 parts by mass in relation to 100 parts by mass of the combined total of the EPDM and butyl rubber.

Butyl rubbers that can be used include uncross-linked regular-type butyl rubbers that are isobutylene-isoprene copolymer rubbers, chlorinated butyl rubbers, brominated butyl rubbers, and partially cross-linked-type butyl rubbers in a partially cross-linked state.

Commercially available butyl rubbers include the JSR Butyl™, Chlorobutyl™, and Bromobutyl™ series from JSR, or the Polysar Butyl™, Chlorobutyl™, and Bromobutyl™ series from Polysar Rubber Corp.

Cross-linked EPDM compositions that can be used in the present invention are obtained by blending a filler, reinforcer, processing aid, softener, cross-linking agent, co-cross-linking agent, vulcanization accelerator, vulcanization accelerator auxiliary, anti-aging agent, or the like into the EPDM described above or into a blended rubber of the EPDM and a butyl rubber, and kneading, molding, and cross-linking.

For the blended agents described above, it is possible to use blended agents that have been used as blending agents for EPDM or butyl rubbers. Blended agents which are particularly preferable in diaphragms for producing photovoltaic modules shall be described below.

Fillers include calcium carbonate, clay, talc, and the like. The blending ratio is 0 to 100 parts by mass of the filler in relation to 100 parts by mass of crude rubber. When 100 parts by mass is exceeded, the rubber strength declines greatly and the durability of the diaphragm is reduced.

Reinforcers include a variety of types of carbon black, white carbon such as silica, and the like. The blending ratio is 30 to 150 parts by mass of the reinforcer in relation to 100 parts by mass of crude rubber. At less than 30 parts by mass, the strength is low, and when 150 parts by mass is exceeded, the rubber has reduced elongation and the durability of the diaphragm is reduced.

Softeners include process oils such as naphthenic process oils, paraffinic process oils, hydrogenation process oils, and semi-synthetic process oils, and the like. The blending ratio is 0 to 90 parts by mass of the softener in relation to 100 parts by mass of crude rubber. When 90 parts by mass is exceeded, the softener bleeds out and contaminates the surface of the photovoltaic module.

Cross-linking agents include sulfur and organic peroxides. The blending ratio is 0.5 to 10 parts by mass of the cross-linking agent in relation to 100 parts by mass of crude rubber. At less than 0.5 parts by mass, the cross-linking is insufficient and strength is lacking, and when 10 parts by mass is exceeded, then there is less elongation and the durability of the diaphragm is reduced.

Examples of organic peroxides include 2,5-dimethyl-2,5-di-t-butyl-peroxyhexane-3, di-t-butyl peroxide, 2,5-dimethyl-2,5-di-t-butyl-peroxyhexane, t-butyl cumyl peroxide, 1,3-bis(t-butylperoxy-isopropyl) benzene, dicumyl peroxide, 4,4-di-t-butyl peroxy butyl valerate, 2,2-di-t-butyl peroxy butane, 1,1-di-t-butyl peroxy-3,3,5-trimethyl cyclohexane, dibenzoyl peroxide, bis(o-methyl benzoyl) peroxide, bis(p-methyl benzoyl) peroxide, and the like.

A known co-cross-linking agent may be used in combination, with the purpose of improving the efficiency of cross-linking by the organic peroxide. Examples of co-cross-linking agents include sulfur, triallyl isocyanurate (TAIC), triallyl cyanurate (TAC), bismaleimide, quinone dioxime, and the like.

A known vulcanization accelerator/vulcanization accelerator auxiliary could be blended, with the purpose of improving the efficiency of cross-linking of sulfur vulcanization. A vulcanization accelerator auxiliary could also be blended with the purpose of improving the efficiency of cross-linking of the organic peroxide cross-linking.

In particular, it is preferable to use an organic peroxide, a co-cross-linking agent, and a vulcanization accelerator in combination. Zinc oxide is a preferable vulcanization accelerator.

A known anti-aging agent could be used as the anti-aging agent. Illustrative examples include amine-based anti-aging agents, phenolic anti-aging agents, and sulfur-based anti-aging agents.

The cross-linked EPDM composition is obtained by molding a sheet or diaphragm of the blended uncross-linked EPDM composition described above, and thereafter cross-linking same.

Adjustments can be made, for example, by first performing several minutes to several tens of minutes of kneading, at an appropriate temperature, of a rubber composition obtained by blending the EPDM, EPDM/butyl rubber blend, a cross-linking agent, and other additives using a mixer such as a Banbury mixer, a kneader, an Intermix mixer, an internal mixer, or rolls; and then withdrawing the kneaded material.

A vulcanizable uncross-linked EPDM composition that has been adjusted by kneading is molded using a variety of molding techniques involving the use of extruders, calender rolls, presses, injection molding machines, transfer molding machines, or the like, the molded product being introduced into a vulcanization tank and vulcanized simultaneously with the molding or after the molding, yielding the intended cross-linked EPDM molded article. Molding may entail the use of a die, or continuous vulcanization without the use of a die would also be possible.

Preferably, when the uncross-linked EPDM composition is cross-linked, the front side and/or reverse side surface of the sheet or diaphragm is comprised bumpy. It is particularly preferable to comprise the bumpy surface that will be in contact with the resin sheet.

Cloth-texturizing, paper-texturizing, matte-film processing, brushing, and other texturizing formats can be adopted. Particularly preferable among these is cloth-texturizing, which has excellent mold-release properties. Cloth-texturizing is a process for imparting a cloth-form texture to a surface, and is obtained by affixing a releasable cloth having a predetermined weave pattern to a sheet-shaped or diaphragm-shaped surface and vulcanizing. After vulcanization, the cloth having this pattern is peeled off. In the present invention, preferably at least the diaphragm surface that is in contact with the resin sheet is cloth-grained. The cloth-graining improves the mold-release properties during production of the photovoltaic modules.

The diaphragm made using the cross-linked EPDM composition or the blend composition with the butyl rubber as in the present invention can be used as a diaphragm for a photovoltaic module, as a diaphragm for a vacuum press device without two-stage cross-linking, under conditions of a hot pressing temperature of 135-180°C and pressing time of 10 to 20 minutes.

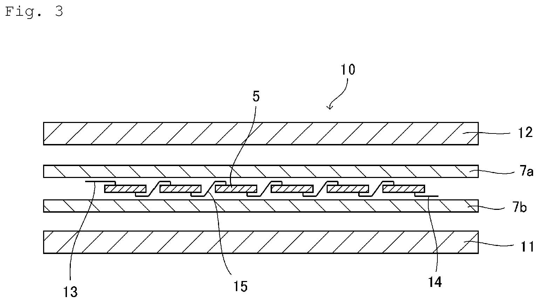

FIG. 3 illustrates a photovoltaic module produced by using the above-described vacuum press device 1. FIG. 3 is a drawing illustrating a cross-sectional structure of a photovoltaic module 10.

The photovoltaic module 10 has a configuration in which photovoltaic cells 5 are sandwiched, with EVA sheets 7a, 7b interposed therebetween, between a transparent cover glass 11 that is arranged on the lower side and a transparent reverse side material 12, such as, for example, a polyethylene resin, that is arranged on the upper side. The photovoltaic cells 5 are of a configuration in which a plurality of photovoltaic cells 5 are arranged between electrodes 13, 14 and connected with a lead line 15.

The photovoltaic module 10 is obtained by using the vacuum press device 1 to laminate while also heating these constituent members, superimposed atop each other, in a vacuum. As a result, solely under one-stage cross-linking, the photovoltaic module is produced by the EVA sheets 7a, 7b being cross-linked and affixed together with each of the constituent members being superimposed atop one another.

### EXAMPLES

### Examples 1 through 6 (not part of the present invention) and Comparative examples 1 through 4

Rubber compositions kneaded with the blends illustrated in table 2 were calendered into sheets 3 mm thick, and cross-linked for 30 minutes at 170°C. The units of the blending ratios are parts by mass; the silicone rubber in comparative example 1 was cross-linked under 30 minutes of one-stage cross-linking at 170°C and 4 hours of two-stage cross-linking at 200°C.

In the rubbers illustrated in table 2, the EPDM 1 has an ethylene content of 51 mass%, a propylene content of 40.9 mass%, and a 5-ethylidene-2-norbornene (diene) content of 8.1 mass%; the EPDM 2 has an ethylene content of 70 mass%, a propylene content of 25.1 mass%, and a 5-ethylidene-2-norbornene (diene) content of 4.9 mass%; and the EPDM 3 has an ethylene content of 56 mass%, a propylene content of 39.3 mass%, and a 5-ethylidene-2-norbornene (as the diene) content of 4.7 mass%.

The butyl rubber was a chlorinated butyl rubber; the ethylene propylene rubber ("EPM") had an ethylene content of 52 mass% and a propylene content of 48 mass%; and the silicone rubber was a high-tear silicone compound mainly composed of silicone crude rubber and silica.

A fatty acid amide was used as a processing aid. The softener was a process oil and the reinforcing agent was carbon black. The cross-linking agent 1 is an organic peroxide and the cross-linking agent 2 is sulfur. The co-cross-linking agent used was a trifunctional-type methacrylate; the vulcanization accelerator was a sulfenamide and thiazole, the vulcanization accelerator auxiliary was zinc oxide, and the anti-aging agent was an amine.

50 × 50 mm sample pieces were prepared from the resulting cross-linked rubber sheets, and hardening associated with thermal degradation of the cross-linked rubber sheets was assessed. Because rubber experiences an increase in hardness associated with an increase in cross-link density, the cross-linked rubber sheet surfaces were coated with a peroxide and hardening associated with thermal degradation was measured as an accelerated test.

The peroxide-coated surfaces also included thermal degradation simultaneously with the hardening (change in hardness) caused by the peroxide. The reverse sides not coated with the peroxide also manifested changes in hardness caused by simple thermal degradation. Both were measured to be able to confirm whether the factors of changes in hardness were more impacted by peroxide degradation or thermal degradation. It is preferable for a diaphragm for producing a photovoltaic module to have little change in hardness on both the front and reverse sides. Under hot press conditions, it is especially important for the front surface to have little change in hardness, in terms of countering the peroxide generated from the EVA. When the rubber hardness increases, the diaphragm is more susceptible to cracking, and when the rubber hardness decreases, the rubber softens.

The method of assessment is illustrated below.
(1) A stock solution of 2,5-dimethyl-2,5-di(t-butylperoxy)hexane (Perhexa 25B™) was prepared, as a peroxide. One side of the sample pieces (indicated with the word "front" for the measurement points in table 2) was twice coated with this stock solution using a brush of a brush length of 15 mm.
(2) For the impact of heating alone, the hardness of the one side of the sample pieces not coated with the peroxide stock solution (indicated with the word "reverse" for the measurement points in table 2) was compared.
(3) One 15-min cycle of heating at 150°C was performed. 40 cycles were repeated, one cycle representing coating with the Perhexa 25B, 15 minutes of heating at 150°, and cooling to room temperature. The rubber hardness (IRHD) of the front side and reverse side of the sample pieces was measured every tenth cycle of treatment. The rubber hardness (IRHD) was measured using a Wallace hardness tester. The results are shown in table 2. The value of the ratio of [hardness after the 40th cycle/hardness of the initial value (where the number of cycles of treatment is a value of 0)] is indicated in table 2 as the rate of change.

**[Table 2]**

| | | | Example | | | | | | Comparative example | | | |
|---|---|---|---|---|---|---|---|---|---|---|---|---|
| | | | 1 | 2 | 3 | 4 | 5 | 6 | 1 | 2 | 3 | 4 |
| Rubber | | | | | | | | | | | | |
| | EPDM 1 | | 100 | - | - | - | - | - | - | - | - | - |
| | EPDM 2 | | - | 100 | - | - | - | - | - | - | - | - |
| | EPDM 3 | | - | - | 100 | 100 | 75 | 50 | - | - | 25 | - |
| | Butyl rubber | | - | - | - | - | 25 | 50 | - | - | 75 | 100 |
| | Silicone rubber | | - | - | - | - | - | - | 100 | - | - | - |
| | EPM | | - | - | - | - | - | - | - | 100 | - | - |
| Blended agents | | | | | | | | | | | | |
| | Processing aid | | 5 | 5 | 5 | 11.5 | 11.5 | 11.5 | - | 5 | 11.5 | 11.5 |
| | Filler | | - | - | - | - | - | - | - | - | - | - |
| | Reinforcer | | 70 | 70 | 70 | 55 | 55 | 55 | - | 70 | 55 | 55 |
| | Softener | | 4 | 4 | 4 | 10 | 10 | 10 | - | 4 | 10 | 10 |
| | Cross-linking agent 1 | | 4 | 4 | 4 | - | - | - | 0.4 | 4 | - | - |
| | Cross-linking agent 2 | | - | - | - | 6 | 6 | 6 | - | - | 6 | 6 |
| | Co-Cross-linking agent | | 3 | 3 | 3 | - | - | - | - | 3 | - | - |
| | Vulcanization accelerator | | - | - | - | 1.3 | 1.3 | 1.3 | - | - | 1.3 | 1.3 |
| | Vulcanization accelerator auxiliary | | 5 | 5 | 5 | - | - | - | - | 5 | - | - |
| | Anti-aging agent | | 1 | 1 | 1 | - | - | - | - | 1 | - | - |
| Assessment testing | | | | | | | | | | | | |
| | Number of cycles of treatment | Measurement location | | | | | | | | | | |
| | 0 | Front | 64 | 86 | 65 | 60 | 56 | 52 | 44 | 58 | 48 | 47 |
| | | Reverse | 63 | 85 | 64 | 59 | 55 | 51 | 43 | 57 | 48 | 47 |
| | 10 | Front | 64 | 83 | 65 | 60 | 56 | 50 | 46 | 58 | 46 | 42 |
| | | Reverse | 63 | 82 | 64 | 59 | 56 | 52 | 46 | 56 | 47 | 45 |
| | 20 | Front | 66 | 85 | 62 | 61 | 58 | 49 | 49 | 45 | 43 | 37 |
| | | Reverse | 66 | 86 | 65 | 61 | 58 | 54 | 46 | 60 | 50 | 47 |
| | 30 | Front | 67 | 79 | 55 | 61 | 57 | 47 | 51 | 35 | 36 | 28 |
| | | Reverse | 65 | 80 | 64 | 61 | 57 | 53 | 46 | 58 | 48 | 44 |
| | 40 | Front | 69 | 77 | 56 | 62 | 57 | 46 | 54 | 32 | 34 | - |
| | | Reverse | 64 | 81 | 64 | 59 | 56 | 52 | 47 | 58 | 48 | 43 |
| | Rate of change | Front | 1.08 | 0.90 | 0.86 | 1.03 | 1.02 | 0.88 | 1.23 | 0.55 | 0.71 | - |
| | | Reverse | 1.02 | 0.95 | 1.00 | 1.00 | 1.02 | 1.02 | 1.09 | 1.02 | 1.00 | 0.91 |

Each of the examples, even in accelerated testing, had less of a change in rubber hardness than the conventional diaphragm made of silicone rubber. Blending the butyl rubber into the EPDM also minimized rubber hardening. Softening of the rubber was observed with a cross-linked EPM composition (comparative example 2) and a cross-linked EPDM composition into which 75 parts by mass of butyl rubber was blended (comparative example 3). When a composition of cross-linked butyl rubber alone (comparative example 4) was treated for more than 20 cycles, it was noted that dissolved rubber was attached to the brush.

Each of the diaphragms obtained by the example 1 and the comparative example 1 was attached to the pressing device 1 illustrated in FIG. 1 and the photovoltaic module 10 illustrated in FIG. 3 was produced by a format of carrying out only the one-stage cross-linking.

In the results, in contrast to the diaphragm of comparative example 1, the diaphragm of example 1 remained usable for 1.56 times as many cycles of pressing at the hot pressing conditions A (20 minutes at 155°C) and 6.8 times as many cycles of pressing at the hot pressing conditions B (15 minutes at 165°C).

The diaphragm of the present invention improves the productivity of producing photovoltaic modules, because the diaphragms are replaced with less frequency.

Also, photovoltaic modules produced by using the diaphragm of the present invention, in terms of performance of the photovoltaic modules, have shown no significant difference in the products of the initial stages and later stages of production.

### Example 7 through example 16 (Examples 7 to 11 are not part of the present invention)

Rubber compositions kneaded with the blends illustrated in table 3 were calendered into sheets 3 mm thick, and cross-linked for 30 minutes at 170°C. The blending ratios are indicated as parts by mass.

In the rubbers illustrated in table 3, the EPDM 4 has an ethylene content of 52 mass% and a diene content of 8.1 mass%, the EPDM 5 has an ethylene content of 54 mass% and a diene content of 8 mass%, the EPDM 6 has an ethylene content of 56 mass% and a diene content of 8 mass%, the EPDM 7 has an ethylene content of 59 mass% and a diene content of 9 mass%, the EPDM 8 has an ethylene content of 45 mass% and a diene content of 7.6 mass%, the EPDM 9 has an ethylene content of 70 mass% and a diene content of 4.9 mass%, the EPDM 10 has an ethylene content of 55 mass% and a diene content of 5 mass%, and the EPDM 11 has an ethylene content of 55 mass% and a diene content of 2.3 mass%.

Among the EPDMs illustrated in table 3, the EPDM 1 and the EPDM 3 to EPDM 6 are obtained using a vanadium-based catalyst, which is a multi-site catalyst, and the EPDM 7 to EPDM 11 are polymerized using a single-site catalyst such as a metallocene catalyst.

In table 2 and table 3, the EPDM 1 is Mitsui EPT 4021™ From Mitsui Chemical. The EPDM 2 and EPDM 9 are Nordel IP4725P™ from DuPont & Dow Elastomer. The EPDM 3 is Mitsui EPT 3045™ from Mitsui Chemical. The EPDM 4 is JSR EP33™ from JSR. The EPDM 5 is Mitsui EPT 4045™ from Mitsui Chemical. The EPDM 6 is Mitsui EPT 4070™ from Mitsui Chemical. The EPDM 7 is Nordel IP 5565™ from DuPont & Dow Elastomer. The EPDM 8 is Mitsui EPT 4045M™ from Mitsui Chemical. The EPDM 10 is Nordel IP 4640™ from DuPont & Dow Elastomer. The EPDM 11 is "Mitsui EPT 2060M™ from Mitsui Chemical.

A fatty acid amide and fatty acid salt were used as the processing aids illustrated in table 3. The softener was a process oil and the reinforcing agent was a carbon black. The cross-linking agent was an organic peroxide, while the co-cross-linking agent, vulcanization accelerator auxiliary, and anti-aging agent were a trifunctional methacrylate system, zinc oxide system, and amine system, respectively.

50 x 50 mm sample pieces were prepared from the resulting cross-linked rubber sheets, and hardening associated with thermal degradation of the cross-linked rubber sheets was assessed similarly with respect to example 1. The results are shown in Table 3.

**[Table 3]**

| | | | Example | | | | | | | | | |
|---|---|---|---|---|---|---|---|---|---|---|---|---|
| | | | 7 | 8 | 9 | 10 | 11 | 12 | 13 | 14 | 15 | 16 |
| Rubber | | | | | | | | | | | | |
| | EPDM 1 | | 100 | 50 | 50 | 50 | 50 | 50 | 50 | 50 | 50 | 50 |
| | EPDM 3 | | - | 50 | - | - | - | - | - | - | - | - |
| | EPDM 4 | | - | - | 50 | - | - | - | - | - | - | - |
| | EPDM 5 | | - | - | - | 50 | - | - | - | - | - | - |
| | EPDM 6 | | - | - | - | - | 50 | - | - | - | - | - |
| | EPDM 7 | | - | - | - | - | - | 50 | - | - | - | - |
| | EPDM 8 | | - | - | - | - | - | - | 50 | - | - | - |
| | EPDM 9 | | - | - | - | - | - | - | - | 50 | - | - |
| | EPDM 10 | | - | - | - | - | - | - | - | - | 50 | - |
| | EPDM 11 | | - | - | - | - | - | - | - | - | - | 50 |
| Blended agents | | | | | | | | | | | | |
| | Processing aid | | 5 | 5 | 5 | 5 | 5 | 5 | 5 | 5 | 5 | 5 |
| | Reinforcer | | 70 | 70 | 70 | 70 | 70 | 70 | 70 | 70 | 70 | 70 |
| | Softener | | 4 | 4 | 4 | 4 | 4 | 4 | 4 | 4 | 4 | 4 |
| | Cross-linking agent | | 2.5 | 2.5 | 2.5 | 2.5 | 2.5 | 2.5 | 2.5 | 2.5 | 2.5 | 2.5 |
| | Co-Cross-linking agent | | 4 | 4 | 4 | 4 | 4 | 4 | 4 | 4 | 4 | 4 |
| | Vulcanization accelerator auxiliary | | 5 | 5 | 5 | 5 | 5 | 5 | 5 | 5 | 5 | 5 |
| | Anti-aging agent | | 1 | 1 | 1 | 1 | 1 | 1 | 1 | 1 | 1 | 1 |
| Normal-state physical properties | | | | | | | | | | | | |
| | Tensile strength (Mpa) | | 14.6 | 14.8 | 15.8 | 15.7 | 16.1 | 16.7 | 14.4 | 16.7 | 14.6 | 19.5 |
| | Extension (%) | | 350 | 350 | 330 | 390 | 310 | 350 | 370 | 370 | 390 | 410 |
| Assessment testing | | | | | | | | | | | | |
| | Number of cycles of cycles treatment | Measurement location | | | | | | | | | | |
| | 0 | Front | 63 | 65 | 62 | 62 | 67 | 65 | 62 | 74 | 64 | 64 |
| | | Reverse | 63 | 65 | 62 | 62 | 67 | 65 | 63 | 74 | 65 | 65 |
| | 20 | Front | 66 | 66 | 67 | 64 | 68 | 67 | 65 | 74 | 63 | 63 |
| | | Reverse | 64 | 66 | 65 | 64 | 68 | 67 | 65 | 76 | 65 | 67 |
| | 40 | Front | 70 | 72 | 72 | 65 | 71 | 65 | 64 | 74 | 64 | 62 |
| | | Reverse | 65 | 68 | 67 | 66 | 69 | 69 | 68 | 76 | 67 | 69 |
| | Rate of change | Front | 1.11 | 1.11 | 1.16 | 1.05 | 1.06 | 1.00 | 1.03 | 1.00 | 1.00 | 0.97 |
| | | Reverse | 1.03 | 1.05 | 1.08 | 1.06 | 1.03 | 1.06 | 1.08 | 1.03 | 1.03 | 1.06 |

The rates of change for the EPDMs that were polymerized using the single-site catalyst (examples 12 to 16) were 0.97 to 1.08, and the rates of change for the EPDMs that were polymerized using the multi-site catalyst (examples 7 to 11) were 1.03 to 1.16. These values show that the rubber hardness of EPDMs polymerized using a single-site catalyst is more durable than that of EPDMs polymerized using a multi-site catalyst.

### Example 17 through example 25

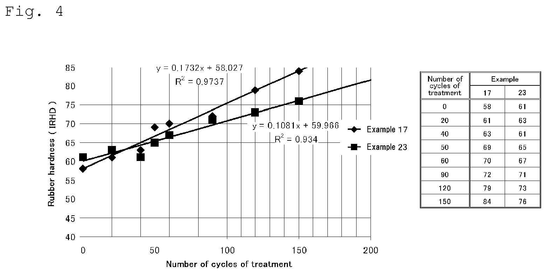

The EPDM 1 that was polymerized using the multi-site catalyst and the EPDM 10 that was polymerized using the single-site catalyst were used to obtain rubber compositions kneaded at the blends illustrated in FIG. 4, which were calendered into sheets 3 mm thick and then cross-linked for 30 minutes at 170°C. The blending ratios are expressed in terms of parts by mass. Example 17 is the same blending as that of example 7, and example 23 is the same blending as example 15, but the sheet preparation timing and assessment timing were different. Example 23, obtained by blending 50 parts by mass of the EPDM 10, had a higher rubber hardness on the front side and reverse side of the sample piece than example 17. This trend is consistent with the fact that the initial value of rubber hardness of example 15 was higher than that of example 7.

50 x 50 mm sample pieces were prepared from the resulting cross-linked rubber sheets, and hardening associated with thermal degradation of the cross-linked rubber sheets was assessed similarly with respect to example 1. The results are shown in Table 4.

**[Table 4]**

| | | | Example | | | | | | | | |
|---|---|---|---|---|---|---|---|---|---|---|---|
| | | | 17 | 18 | 19 | 20 | 21 | 22 | 23 | 24 | 25 |
| Rubber | | | | | | | | | | | |
| | EPDM 1 | | 100 | 95 | 90 | 75 | 70 | 60 | 50 | 25 | 0 |
| | EPDM 10 | | 0 | 5 | 10 | 25 | 30 | 40 | 50 | 75 | 100 |
| Blended agents | | | | | | | | | | | |
| | Processing aid | | 5 | 5 | 5 | 5 | 5 | 5 | 5 | 5 | 5 |
| | Reinforcer | | 70 | 70 | 70 | 70 | 70 | 70 | 70 | 70 | 70 |
| | Softener | | 4 | 4 | 4 | 4 | 4 | 4 | 4 | 4 | 4 |
| | Cross-linking agent | | 2.5 | 2.5 | 2.5 | 2.5 | 2.5 | 2.5 | 2.5 | 2.5 | 2.5 |
| | Co-Cross-linking agent | | 4 | 4 | 4 | 4 | 4 | 4 | 4 | 4 | 4 |
| | Vulcanization accelerator auxiliary | | 5 | 5 | 5 | 5 | 5 | 5 | 5 | 5 | 5 |
| | Anti-aging agent | | 1 | 1 | 1 | 1 | 1 | 1 | 1 | 1 | 1 |
| Assessment testing | | | | | | | | | | | |
| | Number of cycles of treatment | Measurement location | | | | | | | | | |
| | 0 | Front | 58 | 61 | 61 | 60 | 61 | 61 | 61 | 62 | 64 |
| | | Reverse | 59 | 60 | 59 | 60 | 60 | 61 | 61 | 63 | 65 |
| | 20 | Front | 61 | 64 | 63 | 64 | 63 | 63 | 63 | 64 | 65 |
| | | Reverse | 59 | 61 | 58 | 60 | 61 | 61 | 60 | 63 | 62 |
| | 40 | Front | 63 | 68 | 66 | 64 | 63 | 62 | 61 | 61 | 62 |
| | | Reverse | 64 | 65 | 62 | 62 | 62 | 62 | 62 | 62 | 61 |
| | Rate of change | Front | 1.09 | 1.11 | 1.08 | 1.07 | 1.03 | 1.02 | 1.00 | 0.98 | 0.97 |
| | | Reverse | 1.08 | 1.08 | 1.05 | 1.03 | 1.03 | 1.02 | 1.02 | 0.98 | 0.94 |

At higher ratios of EPDM 10, which was polymerized using the single-site catalyst, the rubber hardness imparted by the peroxide tended to decrease and the rate of change in the rubber hardness tended to decreased.

FIG. 4 illustrates the results obtained from assessing examples 17 and 23 up to 150 treatment cycles. FIG. 4 illustrates the relationship between the rubber hardness and the number of cycles of treatment. The rubber hardness was measured on the "front", and the right side of the graph shows the actual values.

In FIG. 4, the rubber hardness and the number of cycles of treatment exhibit a strong first-order correlation, where rubber hardness increases in linear fashion as the number of cycles of treatment increases. The slope of the straight line is smaller for example 23 than for example 17. That is to say, in the accelerated testing, the rubber hardness did not increase but rather maintained its initial state.

These results show that in terms of diaphragms, an EPDM that has been polymerized using a single-site catalyst is more durable than an EPDM polymerized using a multi-site catalyst.

The results of physical testing under identical conditions for examples 17 and 23 show that the diaphragm of example 17 cracked at the 5,400th cycle, and the diaphragm of example 23 cracked at the 7,400th cycle. The scaling factor for when cracking occurred (7,400/5,400) is 1.37. The rubber hardness at the time was 80.

FIG. 4 shows that the number of cycles of treatment at which a rubber hardness of 80 was reached was determined to be 130 cycles for example 17 and 180 cycles for example 23, giving a scaling factor (= 180/130) of 1.38. This shows that the present accelerated testing enabled accelerated assessment of diaphragms for producing photovoltaic modules, and that diaphragms made using an EPDM had excellent durability, and in particular the diaphragms for producing photovoltaic cells where the EPDMs were polymerized using the single-site catalyst had superior durability to the EPDMs that were polymerized using the multi-site catalyst.

### INDUSTRIAL APPLICABILITY

The diaphragm made of cross-linked EPDM as in the present invention can be utilized for future mass production of photovoltaic modules, because the productivity of making photovoltaic modules is improved thereby and photovoltaic modules can be stably produced.

### EXPLANATION OF REFERENCE NUMERALS AND SYMBOLS

- 1: Vacuum press device
- 2: Diaphragm
- 3: First chamber
- 4: Second chamber
- 5: Photovoltaic cell
- 6: Structural support
- 7: EVA sheet
- 8: Cracking
- 9: Crazing
- 10: Photovoltaic module
- 11: Cover glass
- 12: Reverse side material
- 13: Electrode
- 14: Electrode
- 15: Lead line

## Claims

1. A rubber diaphragm (2) for a vacuum press device (1) that is used in producing a photovoltaic module (10), the diaphragm for producing a photovoltaic module being **characterized in that**:
the rubber diaphragm is a sheet of a cross-linked rubber composition that is used in order to laminate photovoltaic cells (5) with resin sheets by hot pressing using the vacuum press device;
the cross-linked rubber composition is a cross-linked rubber composition of an ethylene propylene diene rubber;
the cross-linked rubber composition is obtained by cross-linking a rubber composition comprising the ethylene propylene diene rubber, a cross-linking agent, and at least one selected from vulcanization accelerators and vulcanization accelerator auxiliaries; and
the ethylene propylene diene rubber comprises an ethylene propylene diene rubber that has been polymerized using a single-site catalyst, the ratio of the ethylene propylene diene rubber that has been polymerized using the single-site catalyst to the total amount of the ethylene propylene diene rubber being 10 mass% or more.

2. The diaphragm (2) for producing a photovoltaic module (10) as set forth in claim 1, **characterized in that** a surface that comes into contact with at least the resin sheets when the hot pressing is carried out comprises a bumpy surface.

3. The diaphragm (2) for producing a photovoltaic module (10) as set forth in claims 1 or 2, **characterized in** being ethylene propylene diene rubber in which a butyl rubber is further blended with the ethylene propylene diene rubber in an amount of less than 75 parts by mass in relation to 100 parts by mass of the sum of the ethylene propylene diene rubber and the butyl rubber.

4. A method for producing a photovoltaic module (10), the method comprising laminating a photovoltaic cell using ethylene vinyl acetate resin sheets, the method being **characterized by** comprising:
a step in which the photovoltaic cell is laminated by the ethylene vinyl acetate resin sheets being cross-linked by hot pressing using a vacuum press device in which a diaphragm (2) made of a cross-linked rubber composition is used;
the diaphragm made of a cross-linked rubber composition being the diaphragm for producing a photovoltaic module as set forth in any of claims 1 to 3.

5. The method for producing a photovoltaic module (10) as set forth in claim 4, **characterized in that** the step for laminating by cross-linking by the hot pressing is a step for cross-linking the ethylene vinyl acetate resin sheets by a one-stage cross-linking.

## Patentansprüche

1. Gummimembran (2) für eine Vakuumpresse-Vorrichtung (1), die bei der Herstellung eines photovoltaischen Moduls (10) verwendet wird, wobei die Membran zur Herstellung eines photovoltaischen Moduls **dadurch gekennzeichnet ist, dass**:
die Gummimembran eine Folie einer vernetzten Gummizusammensetzung ist, die zum Laminieren der photovoltaischen Zellen (5) mit Harzfolien durch Heißpressen unter Verwendung der Vakuumpresse-Vorrichtung verwendet wird;
die vernetzte Gummizusammensetzung eine vernetzte Gummizusammensetzung eines Ethylen-Propylen-Dien-Kautschuks ist;
die vernetzte Gummizusammensetzung durch das Vernetzen einer Gummizusammensetzung erhalten wird, die den Ethylen-Propylen-Dien-Kautschuk, ein Vernetzungsmittel und zumindest eines ausgewählt aus Vulkanisationsbeschleuniger und Vulkanisationsbeschleuniger-Hilfsstoffen umfasst, und
der Ethylen-Propylen-Dien-Kautschuk ein Ethylen-Propylen-Dien-Kautschuk umfasst, der unter Verwendung eines Single-Site-Katalysators polymerisiert wurde, wobei das Verhältnis des Ethylen-Propylen-Dien-Kautschuks, der unter Verwendung eines Single-Site-Katalysators polymerisiert wurde, zur Gesamtmenge des Ethylen-Propylen-Dien-Kautschuks 10 Masse-% oder mehr beträgt.

2. Membran (2) zur Herstellung eines photovoltaischen Moduls (10) nach Anspruch 1, **dadurch gekennzeichnet, dass** eine Oberfläche, die mit zumindest den Harzfolien in Kontakt kommt, wenn das Heißpressen durchgeführt wird, eine unebene Oberfläche umfasst.

3. Membran (2) zur Herstellung eines photovoltaischen Moduls (10) nach Anspruch 1 oder 2, **dadurch gekennzeichnet, dass** sie Ethylen-Propylen-Dien-Kautschuk ist, bei dem ein Butylkautschuk ferner mit dem Ethylen-Propylen-Dien-Kautschuk in einer Menge von weniger als 75 Massenteile in Bezug auf 100 Massenteile der Summe des Ethylen-Propylen-Dien-Kautschuks und des Butylkautschuks vermischt wird.

4. Verfahren zur Herstellung eines photovoltaischen Moduls (10), wobei das Verfahren das Laminieren einer photovoltaischen Zelle unter Verwendung von Ethylenvinylacetatharzfolien umfasst, wobei das Verfahren **gekennzeichnet ist:**
**durch** einen Schritt, bei dem die photovoltaische Zelle durch die Ethylenvinylacetatharzfolien laminiert wird, die durch Heißpressen unter Verwendung einer Vakuumpresse-Vorrichtung bei der eine aus einer vernetzten Gummizusammensetzung bestehenden Membran (2) verwendet wird, vernetzt wurden;
**dadurch**, dass die aus einer vernetzten Gummizusammensetzung bestehenden Membran die Membran zur Herstellung eines photovoltaischen Moduls nach einem der Ansprüche 1 bis 3 ist.

5. Verfahren zur Herstellung eines photovoltaischen Moduls (10) nach Anspruch 4, **dadurch gekennzeichnet, dass** der Schritt des Laminierens durch Vernetzen durch das Heißpressen ein Schritt zum Vernetzen der Ethylenvinylacetatharzfolien durch ein einstufiges Vernetzen ist.

## Revendications

1. Diaphragme en caoutchouc (2) pour un dispositif de pression par le vide (1) qui est utilisé pour produire un module photovoltaïque (10), le diaphragme permettant de produire un module photovoltaïque étant **caractérisé en ce que** :
le diaphragme en caoutchouc est une feuille d'une composition de caoutchouc réticulé qui est utilisée afin de stratifier des cellules photovoltaïques (5) avec des feuilles de résine par pressage à chaud à l'aide du dispositif de pression par le vide ;
la composition de caoutchouc réticulé est une composition de caoutchouc réticulé constituée d'un caoutchouc éthylène-propylène-diène ;
la composition de caoutchouc réticulé est obtenue par réticulation d'une composition de caoutchouc comprenant le caoutchouc éthylène-propylène-diène, un agent de réticulation, et au moins un produit sélectionné parmi des accélérateurs de vulcanisation et des auxiliaires d'accélérateur de vulcanisation ; et
le caoutchouc éthylène-propylène-diène comprend un caoutchouc éthylène-propylène-diène qui a été polymérisé à l'aide d'un catalyseur à site unique, le rapport du caoutchouc éthylène-propylène-diène qui a été polymérisé à l'aide du catalyseur à site unique sur la quantité totale du caoutchouc éthylène-propylène-diène étant supérieur ou égal à 10 % en masse.

2. Diaphragme (2) permettant de produire un module photovoltaïque (10) selon la revendication 1, **caractérisé en ce qu'**une surface qui vient en contact avec au moins les feuilles de résine lorsque le pressage à chaud est mis en oeuvre comprend une surface bosselée.

3. Diaphragme (2) permettant de produire un module photovoltaïque (10) selon la revendication 1 ou 2, **caractérisé en ce qu'**il est constitué de caoutchouc éthylène-propylène-diène dans lequel un caoutchouc butyle est en outre mélangé avec le caoutchouc éthylène-propylène-diène en une quantité inférieure à 75 parties en masse pour 100 parties en masse de la somme du caoutchouc éthylène-propylène-diène et du caoutchouc butyle.

4. Procédé de production d'un module photovoltaïque (10), ledit procédé comprenant une étape consistant à stratifier une cellule photovoltaïque à l'aide de feuilles de résine d'éthylène-acétate de vinyle, ledit procédé étant **caractérisé en ce qu'**il comprend :
une étape dans laquelle la cellule photovoltaïque est stratifiée grâce aux feuilles de résine d'éthylène-acétate de vinyle réticulées par pressage à chaud à l'aide d'un dispositif de pression par le vide au sein duquel est utilisé un diaphragme (2) constitué d'une composition de caoutchouc réticulé ;
le diaphragme constitué d'une composition de caoutchouc réticulé étant le diaphragme permettant de produire un module photovoltaïque selon l'une quelconque des revendications 1 à 3.

5. Procédé de production d'un module photovoltaïque (10) selon la revendication 4, **caractérisé en ce que** l'étape consistant à stratifier avec réticulation grâce au pressage à chaud est une étape consistant à réticuler les feuilles de résine d'éthylène-acétate de vinyle grâce à une réticulation en une étape.
